(19) Europäisches Patentamt
European Patent Office
Office européen des brevets

(11) EP 3 191 876 B1

(12) EUROPEAN PATENT SPECIFICATION

(45) Date of publication and mention of the grant of the patent:
**16.06.2021 Bulletin 2021/24**

(21) Application number: **15759624.8**

(22) Date of filing: **20.08.2015**

(51) Int Cl.:
***G02B 1/02*** *(2006.01)* ***G02B 1/11*** *(2015.01)*

(86) International application number:
**PCT/CH2015/000121**

(87) International publication number:
**WO 2016/037292 (17.03.2016 Gazette 2016/11)**

# (54) SOLUTION-PROCESSABLE HRI OPTICAL FILMS COMPRISING TITANATE NANOPARTICLES

OPTISCHE FOLIEN MIT TITANAT-NANOPARTIKELN MIT HOHEM BRECHUNGSINDEX

FILMS OPTIQUES À INDICE DE RÉFRACTION ÉLEVÉ COMPRENANT DES NANOPARTICULES DE TITANATE OBTENUES PAR SYNTHÈSE EN SOLUTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.09.2014 EP 14003106**

(43) Date of publication of application:
**19.07.2017 Bulletin 2017/29**

(73) Proprietor: **Avantama AG**
**8712 Stäfa (CH)**

(72) Inventors:
- **LÜCHINGER, Norman Albert**
  **8712 Stäfa (CH)**
- **HARTMEIER, Benjamin**
  **8712 Stäfa (CH)**

(74) Representative: **Grimm, Siegfried**
**E. Blum & Co. AG**
**Vorderberg 11**
**8044 Zürich (CH)**

(56) References cited:
**JP-A- 2008 138 058** **JP-A- 2009 185 166**
**US-A1- 2014 045 323**

- **JING ET AL: "Preparation and Photocatalytic Properties of Core-Shell Nano-TiO2@[alpha]-Al2O3 Microspheres", JOURNAL OF NANOSCIENCE AND NANOTECHNOLOGY, vol. 14, no. 9, 1 September 2014 (2014-09-01), pages 6996-7000, XP055225857,**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 191 876 B1

## Description

The present invention provides new hybrid materials, particularly in the form of thin films or micro lenses, having superior optical properties. The invention further provides for intermediate goods and devices comprising such hybrid materials, and for starting materials to obtain such hybrid materials. The invention also provides for processes of manufacturing said starting materials, said hybrid materials, said intermediate goods; for the use of said starting materials, said hybrid materials, and said intermediate goods.

It is well known that hybrid materials, comprising nanoparticles and polymers, may exhibit desirable optical properties.

Liu et al (WO2010/002562) describe High-RI antireflective films based on zirconia nanoparticles in combination with specific acrylate-phosphate derivatives. The document particularly points to the flexibility of the layers. However, it is considered disadvantageous that the layers obtained according to this document RI values between 1.677 and 1.692 are available only. Further, the layers obtained are only available as layers, having a thickness below 7 microns. For a number of applications, this is not sufficient.

Liu et al (Colloids and Surfaces A: Physicochem. Eng. Aspects 377 (2011) 138-143) disclose high refractive index hybrid films containing TiO2. Although a high RI is reported, the materials disclosed therein show certain drawbacks: As there is a reactive component involved in the formation of the $TiO_2$ network the films need to be cured at high temperatures (140°C). Additionally, reactive components may result in limited storage and shelf life, thus limited industrial applicability. The fact that a sol-gel method is used for the synthesis of the nanoparticles implies that is limited to anatase phase $TiO_2$ particles. Finally, as no surfactant is used for the stabilization of the particles, the method will be strongly limited to certain combinations of solvents and polymer matrices.

Yamazaki et al (EP2586826) describe HIGH-RI hybrid materials based on zirconia nanoparticles, specific resins and sulphur components. The document particularly points to the flexibility of the layers. However, it is considered disadvantageous that the layers obtained according to this document RI values between 1.600 and 1.619 are available only. Further, the process for manufacturing the layers uses sol-gel technology, which is difficult to use in commercial, large-scale applications.

Russo et al (J. of Polym. Sci. Part B, 2012, 50 65-74) disclose a one-pot synthesis of Hybrid materials comprising titanium oxide hydrates / polyvinyl alcohol as well as HIGH-RI films of such hybrid materials. The document particularly points to the simple manufacturing for both the hybrid materials and the devices comprising such hybrid materials in the form of thin films (by solution-processing). However, it is considered disadvantageous that the process for manufacturing the layers uses sol-gel technology, which is difficult to use in commercial, large-scale applications. Further, the hybrid materials of this document show a short shelf life, making it unsuitable for commercial applications.

Bosch-Jimenez et al (J. Colloid and Interface Sci. 2014, 416, 112-118) discloses colloidal titanium oxide nanoparticles capped with TODA and its application in dye sensitized solar cells. The document is silent about HIGH-RI and about hybrid materials.

Gonen Williams (US2014/0045323) discloses nanocomposites of high optical transparency; the disclosed nanocomposites comprise capped semiconductor nanocrystals selected from ZnO, ZrO2, HfO2 only. Specifically, Gonen Williams fails in disclosing nanocrystals of the core-shell type. The document further discloses methods for manufacturing coatings comprising capped nanoparticles / nanocomposites. The methods described therein do however not allow for very high refractive indices.

It is also well known that suspensions comprising nanoparticles have many applications. For example, Furumatsu (JP2006325069) and Sugai (JP2009185166) both disclose inks for ballpoints, these inks comprise titanium oxide, resins, polyalkoxyethylene alkyl ether phosphate, organic solvents and water.

Thus, it is an object of the present invention to mitigate at least some of these drawbacks of the state of the art. In particular, it is an aim of the present invention to provide improved hybrid materials particularly showing excellent optical properties and devices comprising such materials. There is a specific need for hybrid materials showing excellent optical properties (such as high refractive index) and simultaneously good mechanical stability (such as flexibility or durability) and/or good chemical stability (such as photostability). It is a further aim to provide manufacturing methods for the materials and devices that are simple in upscaling.

These objectives are achieved by the hybrid materials according to claim 1, the device according to claim 13 and the methods according to claims 16 - 18. Further aspects of the invention are disclosed in the specification and independent claims, preferred embodiments are disclosed in the specification and the dependent claims.

The present invention will be described in more detail below. It is understood that the various embodiments, preferences and ranges as provided / disclosed in this specification may be combined at will. Further, depending of the specific embodiment, selected definitions, embodiments or ranges may not apply.

Unless otherwise stated, the following definitions shall apply in this specification:
As used herein, the term "a", "an", "the" and similar terms used in the context of the present invention (especially in the context of the claims) are to be construed to cover both the singular and plural unless otherwise indicated herein or

clearly contradicted by the context. As used herein, the terms "including", "containing" and "comprising" are used herein in their open, non-limiting sense.

Percentages are given as weight-%, unless otherwise indicated herein or clearly contradicted by the context.

The term "nanoparticle" is known and particularly relates to solid amorphous or crystalline particles having at least one dimension in the size range of 1 - 100 nm. Preferably, nanoparticles are approximately isometric (such as spherical or cubic nanoparticles). Particles are considered approximately isometric, in case the aspect ratio (longest : shortest direction) of all 3 orthogonal dimensions is 1 - 2. In an advantageous embodiment, the nanoparticles have a mean primary particle size of 2 - 60 nm, preferably 5 - 30 nm (measured by powder X-ray diffraction and calculated by the Scherrer equation, as described later). Nanoparticles may be homogeneous (i.e. having the same chemical composition along its diameter), or may be of the core shell-type (i.e. comprising an inner material of one chemical composition covered by an outer material having another chemical composition).

The term "hybrid material" is known in the field and denotes materials having an inorganic component (such as titanate nanoparticles, as defined herein) and an organic component (such as a polymeric matrix as defined herein).

The term "suspension" is known and relates to a heterogeneous fluid of an internal phase (i.p.) that is a solid and an external phase (e.p.) that is a liquid. In the context of the present invention, the liquid comprises dissolved matrix molecules. In the context of the present invention, a suspension typically has a kinetic stability of at least 1 day (measured according to complete particle sedimentation). In an advantageous embodiment, the invention provides for a composition with a shelf life of more than 7 days, particularly more than 2 months (hydrodynamic size $D_{90}$ of less than 100 nm). The external phase typically comprises one or more solvents, such as water, alcohols and ketones and the like.

The term "matrix" is known in the field and in the context of this invention denotes continuous material encompassing a discontinuous or particulate phase, particularly a nanoparticulate phase.

The term "polymeric matrix" is known in the field and denotes a solid material comprising, and particularly consisting of, matrix molecules whereby monomeric matrix molecules are present in a polymerized state (linearly or crosslinked). Polymeric matrix molecules may additionally be crosslinked (crosslinks between linear polymer chains). The term thus includes homo-polymers, copolymers and polymer blends.

The term "matrix molecules" is known in the field and includes both, organic polymers (polymeric matrix molecules) and organic monomers (monomeric matrix molecules).

The term "solvent" is known in the field and particularly includes water, alcohols, glycol ethers, nitriles, ketones, ethers, aldehydes and polar aprotic solvents.

The above organics can be substituted or unsubstituted and include linear, branched and cyclic derivatives. There can also be unsaturated bonds in the molecule. The above derivatives typically have 1 - 12 carbon atoms, preferably 1 - 7 carbon atoms.

The terms "surfactant", "dispersant" and "dispersing agent" are known in the field and are used synonymously. In the context of the present invention, these terms denote an organic substance, other than a solvent, which is used in suspensions or colloids to improve the separation of particles and to prevent agglomeration or settling. Surfactants, dispersants and dispersing agents can be polymers or small molecules and typically contain functional groups. Surfactants, dispersants and dispersing agents are physically or chemically attached on the particle surface either before or after adding the particles to the external phase. In the context of the present invention, solvent molecules are not considered surfactants, dispersants or dispersing agents.

The term "solution-processing" is known in the field and denotes the application of a coating or thin film to a substrate by the use of a solution-based (=liquid) starting material. In the context of the present invention, solution processing relates to the fabrication of devices and intermediate goods comprising thin nanoparticle hybrid films by the use of one or more liquid suspensions; typically the application of the suspension(s) is/are conducted at ambient pressure and ambient atmosphere. Solution-processing shall include both, coating techniques and printing techniques, as discussed below.

The terms "printing" or "coating" are known in the field and denote specific techniques of solution-processing. There is a variety of different printing or coating types with advantages and drawbacks for each type. A person skilled in the art is in a position to select appropriately. Suitable are, for example coating, particularly roll-to-roll-, slot-die-, spray-, ultrasonic spray-, dip-, reel-to-reel-, blade- coating; or by printing, particularly ink-jet-, pad-, offset-, gravure-, screen-, intaglio-, sheet-to-sheet- printing. Such processes are generally considered advantageous for large-scale production, when compared to vacuum-based processes.

The term "drying" is known in the field and denotes the process of evaporating the solvent in the liquidprocessed film. Many processes are known to remove a liquid from a wet thin film of a coated substrate; a person skilled in the art is in a position to select appropriately. Suitable are, for example drying at room temperature or elevated temperature. Drying may take place in air, in a protecting gas, such as nitrogen or argon. Especially suited are gases with low humidity content (e.g. nitrogen, dry air, argon).

The term "titanates" is known in the field and describes substances containing (i.e. comprising or consisting of) titanium oxides.

The term titanates includes both, crystalline and amorphous materials. Titanates may have a variety of crystal structures such as rutile-type (tetragonal) or perovskite-type (orthorhombic) structure.
The term titanates includes both, stoichiometric or non-stoichiometric materials. Because of possible oxygen vacancies, titanates be stoichiometric or non-stoichiometric, typically they are stoichiometric.
The term titanates includes both, pure and doped titanates. Accordingly, in one embodiment, titanates only contain titanium and oxygen. In one further embodiment, titanates contain additional metals, such as strontium, barium, potassium and/or iron. In the context of the present invention, titanates consist of a single crystal phase, e.g. when analyzed by X-Ray diffraction (XRD). This means that, if other metals than titanium are present in the titantate, the atoms of the other metal substitute titanium atoms in the crystal lattice of the titanium dioxide. Accordingly, mixtures of two different oxides (e.g. titanium oxide and strontium oxide) are excluded and consequently not considered titanates.

The present invention will be better understood by reference to the figures.

Fig. 1 shows a schematic representation of the inventive hybrid material (30), as it may be present in the form of a thin layer in intermediate goods according to fig. 3-5, wherein (1) represents nanoparticles, (2) represents surfactants, (6) represents the polymer matrix, all of them as defined herein.

Fig. 2 shows a schematic flow diagram of manufacturing devices in line with the present invention. First, a suspension (5) is obtained by combining the starting materials (i.e. nanoparticles (1), surfactant (2), solvent (4), matrix molecules (3)). Second, an intermediate (10) is obtained, comprising the inventive hybrid material (30) on a substrate (20)). Third, the intermediate good is assembled to obtain a device (41, 42, 43).

Fig. 3 shows a schematic set-up of two device structures including a light extraction (light outcoupling) layer (30). According to Fig 3, comprising (bottom-up) a substrate (20), the inventive hybrid material (30), transparent electrode (EL), active layer stack, e.g. OLED emitter stack (AL). According to Fig. 3A the interface between the hybrid material and the substrate may be planar and exhibiting a surface roughness below 100 nm. According to Fig. 3B the interface between the hybrid material and the substrate may be microstructed and exhibiting a surface roughness in the micrometer range (e.g. craters or regular patterns with lateral dimensions of > 1 micrometer and < 100 micrometer. Layer (30) and the transparent electrode (EL) are refractive-index-matched. The transparent electrode (EL) can be a transparent conductive oxide (e.g. indium-tin-oxide (ITO), Aluminium doped Zinc oxide (AZO)) or based on metal nanowires such as silver nanowires or copper nanowires.

Fig. 4 shows a schematic set-up of an anti-reflective coating or a Bragg reflector (depending on the applied film thickness), comprising a substrate (20), a layer of low refraction index (LRI), the inventive hybrid material (30), a layer of low refraction index (LRI), the inventive hybrid material (30). By the index "n" it is indicated that more than one of such layer stack may be provided. The integer n is not to be confused with index n used in formula (IV).

Fig. 5 shows a schematic set-up, where the inventive hybrid material (30) is present in the form of microlenses on a substrate (20).

Fig. 6 shows a schematic set-up of a device structure similar to Fig. 3A but comprising larger scattering elements (SE) randomly dispersed within the inventive hybrid material (30). The scattering elements can be inorganic material, organic material or air. The size of the scattering elements is 100 nm - 1000 nm. The refractive index of the scattering elements is < 1.5, preferably < 1.4.

In a first aspect, the invention relates to a solid hybrid material as defined in claim 1.

This aspect of the invention shall be explained in further detail below:
In an advantageous embodiment, the invention relates to a solid hybrid material (30) comprising 50-90 wt-% (preferably 65-88 wt-%, most preferably 75-85 wt-%) nanoparticles (1) , as defined in claim 1, selected from the group of titanates; 1-20 wt-% (preferably 2-10 wt-%, most preferably 4-7 wt-%) surfactants (2) selected from the group of monocarboxylic acids comprising a polyether tail and phosphate esters of alkyl ethers; 9-49 wt-% (preferably 10-30 wt-%, most preferably 11-21%) polymeric matrix (3) selected from the group of acrylate polymers, sulfone polymers, epoxy polymers, vinyl polymers, urethane polymers and imide polymers.

These hybrid materials have outstanding optical properties and mechanical properties and may therefore find applications as outlined herein. These materials are particularly suitable as an IEL layer (internal extraction layer), Bragg reflectors or antireflection coatings for intermediates and devices as discussed below. Particularly important optical and mechanical properties in this context are high refractive index, high transparency, low haze at high thickness, low absorption, high temperature stability, and low surface roughness. These requirements can be met with the materials of the present invention.

These hybrid materials are further very simple in processing. As further outlined below, these materials may be processed in solution, still retaining the beneficial optical and mechanical properties. This avoids vacuum-deposition methods or other expensive manufacturing methods.

Advantageously, the materials (1), (2), (3) are selected to not absorb within the visible wavelength range. Nanoparticles (1) : The term nanoparticles are described above. The nanoparticles are titanates of formula (I),

$$M_xTi_yO_z \qquad (I),$$

wherein

M represents alkaline metal or alkaline earth metal,
x represents 0, a real number below 1 or 1,
y represents 1 or a real number below 1 but excluding 0,
z represents a real number below 1 but excluding 0, provided that
z=x/2+2*y if M represents an alkaline metal or
z=x+2*y if M represents an alkaline earth metal or
z=2*y if x=0.

Particularly suitable titanates are selected from the group consisting of TiO2 (all possible crystalline phases) SrTiO3, BaTiO3.

Very particularly preferred titanates are selected from the group consisting of SrTiO3, TiO2 (rutile phase). Most particularly preferred is SrTiO3.

According to the invention, said titanates may be selected from one single species or from a mixture of species. Accordingly, the inventive hybrid materials may comprise one species of titanate nanoparticles (e.g. pure TiO2) or may comprise two or more species of titanate nanoparticles (e.g. pure TiO2 nanoparticles and pure SrTiO3 nanoparticles). Such selection of species may be helpful for fine-tuning properties as required by the intended use.

According to the invention, said titanates may be stoichiometric or non-stoichiometric compounds as defined herein. In the context of the present invention compounds are considered stoichiometric if the amount of oxygen atoms in the compound strictly follows formula (I) and are considered non-stoichiometric if there is an excess or a lack of oxygen atoms i.e. the actual amount of oxygen is smaller or larger then the value x given in formula (I). These oxygen defects may occur in any of the mentioned titanates.

The nanoparticle size is 2-60nm, preferably 5-30, most preferably 8-18nm. The nanoparticle size corresponds to a mean crystallite size measured by XRD and calculated by the Scherrer equation:

$$\tau = \frac{K\lambda}{\beta \cos(\theta)}$$

wherein;

$\tau$ is the mean size of the crystalline domains
$\kappa$ is a dimensionless shape factor (typically approx. 0.9)
$\lambda$ is the X-ray wavelength
$\beta$ is the peak broadening at the half-maximum (FWHM) after subtracting the instrumental peak broadening
$\theta$ is the Bragg angle.

According to the invention, the nanoparticles may be amorphous. This may be beneficial, e.g. in the case of TiO2 the photocatalytic effect of TiO2 (Anatase) can be reduced (avoid degradation of organic matrix).

According to the invention, the nanoparticles are of a core-shell structure, whereby the core and shell are composed of different oxides. Preferably, the shell does amount to less than 20 wt-% (based on oxide weight) of the whole particle.

The core is composed of a titanate as described in formula (I).

In one embodiment, the shell is composed of titanates as described in formula (I), but different to the core.
In a further preferred embodiment, the shell is composed of other metallic oxides, preferably Al2O3 or ZrO2. This embodiment shows particularly beneficial properties for a number of applications / devices. Although the surface of these nanoparticles (1) comprises metallic oxides other than titanates, these particles are compatible with the surfactants (2) as described herein. Hybrid materials (30) comprising these core-shell nanoparticles are particularly desirous, as outlined below in 2nd aspect of the invention.

**Surfactants (2):** The term surfactants is described above. It was found that two classes of surfactants show very beneficial effects, namely: surfactants selected from the group of monocarboxylic acids comprising a polyether tail and phosphate esters of alkyl ethers. These surfactants are predominantly located on the surface of the nanoparticles. Without being bound to theory, it is believed that these surfactants ensure compatibility between the nanoparticles and the polymer matrix. Secondly, the surfactants of this invention allow high refractive indices of the hybrid material due to the very low amount of surfactant needed per amount of nanoparticles. These surfactants are explained in further detail below.

Advantageously, the above cited monocarboxylic acids are of formula (II),

$$R(OC_nH_{2n})\ qOCH_2C\ (O)\ OH \qquad (II)$$

wherein R is $C_{1-5}$-alkyl, q is an integer from 0 to 5 and n is an integer from 1 to 3.

Five particularly preferred compounds of that class are:

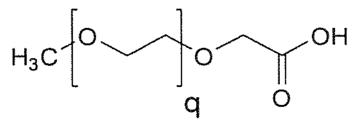

wherein q is from 0-4. This corresponds to a compound of formula (II), wherein R=Methyl, n=2 and q is an integer from 0-4.

A particularly preferred compound of that class is

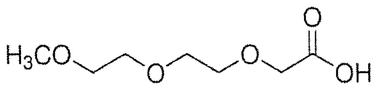

This corresponds to a compound of formula (II), wherein R=Methyl, n=2 and q is 2.

Such surfactants are commercial items or may be obtained according to known procedures.

Advantageously, in the above cited phosphate ester said alkyl ether is of formula (IV),

$$R_4O\text{-}(C_2H_4O)_m(C_3H_6O)_n^- \qquad (IV),$$

wherein $R_4$ is C1-C10-alkyl; m and n are each, independently, 2 to 60.

Accordingly, the alkyl ethers of formula (IV) belong to the class of poly ($C_{2-3}$-alkylene glycol) -mono-$C_{1-10}$-alkyl ethers. Such compounds of formula (IV) do not contain unsaturated double bonds; acryl- and vinyl derivatives are therefore not encompassed.

R may be linear or branched, but is preferably linear. R is especially methyl.

Preferably, m is not less than 2 and especially not less than 3. It is also preferred that m is not greater than 20, more preferably not greater than 10 and especially not greater than 5.

Preferably, n is not less than 3, more preferably not less than 5 and especially not less than 7. It is also preferred that n is not greater than 40, more preferably not greater than 20 and especially not greater than 10.

The ratio of m/n is preferably between 1/1 and 1/10 and especially between 1/2 and 1/5.

The molecular weight of the mono alkyl ether of formula (IV) is preferably less than 6,000, more preferably less than 3,000, even more preferably less than 2,000 and especially less than 1,000. It is also preferred that the molecular weight of the alkyl ether of formula (I) is not less than 200, more preferably not less than 400 and especially not less than 600.

The phosphate esters of alkyl ethers (IV) as described herein may comprise the following compounds:

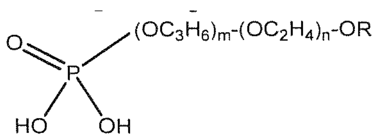

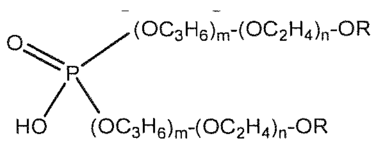

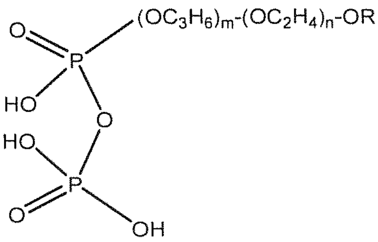

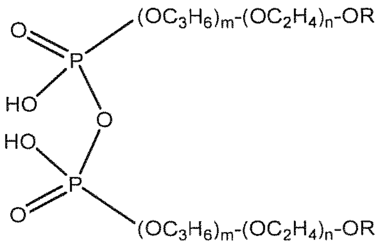

wherein the substituents are as defined hereinbefore. Typically, the first identified compound is the main compound of the composition, forming 50wt-% or more of the composition.

The phosphate esters of alkyl ethers (IV) as described herein contain free OH groups. It is known that such groups are reactive and are particularly susceptible towards salt formation or ester formation. For example, when contacted with the metal oxide nanoparticles, salts such as Zinc phosphates or Aluminum phosphates may be formed. Further, when contacted with solvents, such as alcohols, phosphate esters may be formed. Such salts and esters of the above phosphate esters of alkyl ethers (IV) are encompassed.

The phosphate esters of alkyl ethers (IV) as described herein are commercial items. Such phosphate ester may be made by any method known in the art, and is preferably made by reacting the corresponding alkyl ether with a phosphating agent. Preferred phosphating agents are $H_3PO_4$ $POCl_3$, polyphosphoric acid and especially $P_20_5$.

According to the invention, the phosphate ester may be in the form of a free acid or it may form a salt with an alkali metal, ammonia, an amine, alkanolamine or a quaternary ammonium cation. Preferably, the alkali metal is lithium, potassium and especially sodium.

According to the invention, the phosphate ester may also be further reacted with an alkanol or alkanolamine. Preferred alkanols are $C_{1-6}$- and especially $C_{1-4}$-alkanols. When the phosphate ester is further reacted with the alkanol additional ester groups are formed and the ratio of the monoalkyl ether of formula 1 to the phosphorus atom of the phosphating agent is less than 2 and especially less than 1.5. When the phosphate ester is reacted with an alkanolamine, the alkanolamine may form ester and/or amido groups and/or amine salts. It is believed that the reaction product is mainly an amine salt. Examples of alkanolamines are ethanolamine, diethanolamine, 2-dimethylamino ethanol and 2-amino-2-methyl-1 -propanol.

**Polymeric Matrix** (3): It was found that nanoparticles combined with the surfactants as described herein are compatible with a wide variety of polymers. In principle the concept of the present invention can be applied to any polymer matrix that is compatible with solvents, which themselves are compatible to the disclosed surfactants.

From these polymers, several classes show very beneficial effects, namely selected from the group of acrylate polymers, sulfone polymers, epoxy polymers, vinyl polymers, urethane polymers, imide polymers. Particularly preferred classes of polymers are selected from the group of acrylate polymers, sulfone polymers, epoxy polymers and vinyl polymers. Most particularly preferred classes of polymers are selected from the group of acrylate polymers and sulfone polymers. Further preferred classes of polymers are selected from the group of polyesters, polyfuranes, and melamine resins. It was found that these classes of polymers show beneficial effects on optical, mechanical and/or applicability properties of the coatings as described below (second aspect of the invention).

The polymeric matrix may be either characterized by its repeating units or by the starting materials used for polymerisation. Preferred polymers are outlined below:

Advantageously, the acrylate polymers are obtained from monomers of formula (V-I) or (V-II)

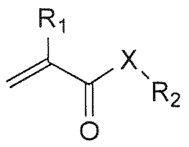 (V-I), 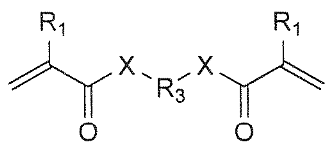 (V-II)

wherein

$R_1$ independently represents hydrogen or methyl;
X independently represents oxygen or sulphur;
$R_2$ represents a substituent selected from phenyl, phenyl-$C_{1-4}$ alkyl, phenyl-oxy and phenyl-oxy-$C_{1-4}$ alkyl;
said phenyl optionally being substituted by 1-3 substituents selected from the group of Cl-4 alkyl, phenyl, halogen, hydroxy.
$R_3$ represents a substituent selected from phenyl, diphenyl (Ph-Ph), diphenylsulfyl (Ph-S-Ph), diphenyloxy (Ph-O-Ph),
said phenyl optionally being substituted by 1-3 substituents selected from the group of Cl-4 alkyl, phenyl, halogen, hydroxy.

Two particularly preferred polymers are obtained from the following monomers:

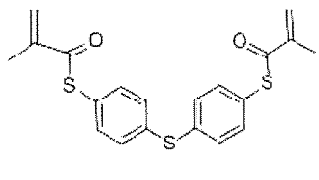

or

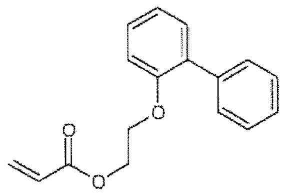

Such polymers (or its monomers respectively) are commercial items and / or available using known methods.
Advantageously, the sulfone polymers are formed by reaction of an aromatic diol with an Di(halogenaryl)sulfone and typically have repeating units of formula (VI),

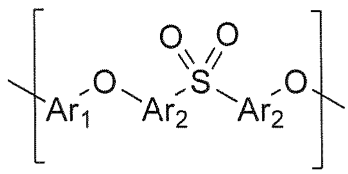

(VI)

wherein

$Ar_1$ represents a phenyl, a phenylether, a phenylthioether, a bisphenol,
said phenyl optionally being substituted by 1-3 substituents selected from the group of C1-4 alkyl, phenyl, halogen, hydroxy.
$Ar_2$ represents phenyl,
said phenyl optionally being substituted by 1-3 substituents selected from the group of Cl-4 alkyl, phenyl, halogen, hydroxy.
$Ar_1$ preferably represents resorcinol, bisphenol A and bisphenol S. Particularly preferred are bisphenol A and bisphenol S.

One particularly preferred polymer of that class has repeating units of formula

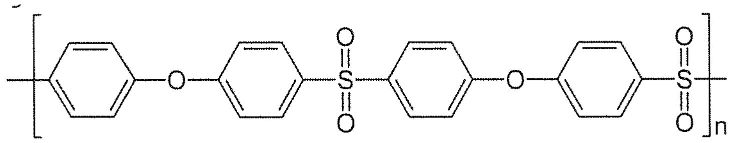

Such polymers (or its monomers respectively) are commercial items and / or available using known methods.
Advantageously Vinyl Polymers comprise repeating units of formula (VII)

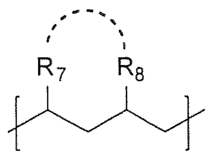

(VII)

wherein

$R_7$ represents hydrogen, $C_{1-4}$ alkyl, hydroxy, cyano, 2-pyrrolidone;
$R_8$ represents hydroxy, cyano, 2-pyrrolidone; OR
wherein
$R_7$, $R_8$ together form a heterocycle (as indicated by the dotted line,
said heterocycle being selected from 1,3-dioxanes
said heterocycle optionally being substituted by 1-3 $C_{1-8}$ alkyl groups.

Such polymers (or its monomers respectively) are commercial items and / or available using known methods.
Two particularly preferred repeating units are of the following formulae:

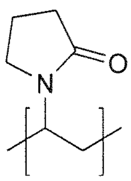

or

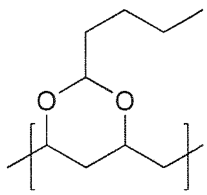

The first structural unit describes the polymer polyvinylpyrrolidone (PVP), while the latter describes the polymer polyvinylbutyral (PVB), which typically comprises additional hydroxy-groups.
The hybrid material may optionally comprise further additives. These additives are part of the polymeric matrix; suitable additives include rheology modifiers (such as PVP K90) and polymerisation initiators (such as Darocur 1173).
The hybrid material may optionally comprise additional elements with a size of 100 nm - 1000 nm, particularly for influencing scattering properties. Such elements may be inorganic particles, organic particles or air inclusions. Hybrid films including such scattering elements may act as IEL or light incoupling layers in lighting devices, displays or solar cells.
As it becomes apparent from the above, a high flexibility is obtained for providing hybrid materials comprising (or consisting of) nanoparticles, surfactants and polymer matrix. This flexibility allows

- to adjust the refractive index between 1.5 and 2.0;
- to adjust film thickness in the range of 30 nm - 30’ 000 nm;
- to obtain highly transparent films (i.e. no haze, even at comparatively thick films (>10 μm));
- to obtain colour-less films (i.e. no absorption of the materials in the visible wave-length);
- to obtain films that are stable toward temperature and mechanical stress.

These benefits are obtained due to the combination of specific starting materials (1), (2) and (3) as outlined herein. Without being bound to theory, it is believed that the specific combination of nanoparticles, surfactants and polymer matrix enable the superior properties of the solid hybrid material as described herein:

From a transparency point of view, the nanoparticles need to be as small as possible in order not to interfere with the visible light. In order to maximize the refractive index however, the particles need to be as large as possible so that as little as possible surfactant is used and as much as possible high refractive index polymer matrix can be added. It is known in the field that a randomly arranged packing of spheres shows a volume density of 50%. As the titanates used in the present invention have a density of approximately 4 to 5 times higher than organic material it follows, that in order to completely fill up the pores of the randomly arranged nanoparticle packing approximately 20 wt-% organic matrix should be combined with 80 wt-% nanoparticles. So if the maximum amount of allowable organic matrix is fixed, the goal is to reduce the amount of surfactant in order to increase the allowable amount of beneficiary polymer matrix material, thus leading to improved optical and mechanical properties. It is therefore also the achievement of the present invention combining optimal nanoparticle size with specific surfactants that only needs minimal application concentrations for complete stabilization and minimal agglomeration of all particles. Finally the choice of the polymer matrix allows for the fulfilment of the second part of properties (Low absorption in the visible light range, High temperature stability (>200°C), Low surface roughness, High mechanical stability) explained herein. Depending on the polymer matrix, one or more of these requirements can be met.

In a **second aspect,** the invention relates to coatings comprising the inventive hybrid material, to intermediate goods comprising such coatings and to devices comprising such intermediate goods

It was surprisingly found that the material described above (first aspect) is suitable for obtaining thin films and microlenses with superior optical properties. Specifically, the materials show:

- high refractive index (>1.75)
- low haze (not visible by eye) at high thickness (>10 μm).

Further, several other attributes may be important for certain applications. These attributes can, depending on the application requirements, be fulfilled separately or in combination. Amongst these are:

- Low absorption in the visible light range
- High temperature stability (>200°C)
- Low surface roughness
- High mechanical stability
- High durability against photoinduced degradation.

This aspect of the invention shall be explained in further detail below:

Coating (30): The term coating shall include both, continuous coatings and dis-continuous coatings. Such coatings may be applied to a substrate by conventional means. Particularly, such coatings may be applied on a substrate already having one or more coatings. Further, additional coatings may be applied on top of the inventive coating.

In one embodiment of the inventive coatings, the hybrid material comprises nanoparticles having a size of 5 - 30 nm, preferably 8 - 18 nm.

In the inventive coatings, the nanoparticles are of the core-shell type, comprising a titanate core according to formula (I), preferably a Ti02 rutile core and a metal oxide shell selected from Al2O3 or ZrO2 shell, preferably a Al2O3 shell. Such coatings retain a desirous high refractive index, but show improved chemical stability when exposed to radiation, such as UV radiation or ambient radiation. These core-shell nanoparticles therefor allow for the manufacturing of hybrid materials in the form of thin layers (i) showing excellent refractive index (e.g. 1.75 or more) in combination with moderate mechanical stability and excellent chemical stability or (ii) showing moderate refractive index (e.g. in the rage of 1.7) in combination with excellent mechanical stability and excellent chemical stability.

In one embodiment, the coating is continuously applied to a substrate. Such coating is referred to as "a layer", the thickness thereof preferably having a thickness of 30nm to 100μm, most preferably of 70 nm - 20 μm. Compared to the prior art, it is possible to obtain relatively thick layers.

In an alternative embodiment, the coating is discontinuously applied to a substrate. Such coating is typically applied in the form of a multitude of "microlenses", the diameter thereof preferably being 1 - 500 μm, most preferably 3 - 30 μm.

Intermediate good (10): The term "intermediate good" is known in the field and relates to goods that are an integral part of devices as outlined below. Such intermediate goods include rigid or flexible substrates coated with the hybrid material of the present invention. Such substrates may me polymeric (e.g. PET, PC, PANI) or inorganic (e.g. metal foils, glass sheets).

The structure of the intermediate good may vary depending on its intended use. Preferred are intermediate goods having the structure according to fig. 3 or having the structure according to fig. 4; or having the structure according to fig. 5; or having the structure of fig. 6. Accordingly, the invention provides for an intermediate good having either of the following (bottom-up) structures:

- Substrate (preferably planar, surface roughness below 100nm) (20) / inventive hybrid material (30) / transparent electrode (EL) / active layer stack, e.g. OLED emitter stack (AL); thus acting as an index matching layer [Fig. 3A] or
- Substrate (preferably microstructured, surface roughness in the micrometer range below 100 micrometer) (20) / inventive hybrid material (30) / transparent electrode (EL) / active layer stack, e.g. OLED emitter stack (AL); thus acting as a light extraction layer [Fig. 3B] or
- Substrate (20) / multiple units of low refractive index layer (LRI) and the inventive hybrid material (30) or Substrate (20) / multiple units of the inventive hybrid material (30) and low refractive index layer (LRI), thus acting as a bragg reflector or anti reflection coating[Fig. 4] or
- substrate (20) / the inventive hybrid material (30) in the form of micro-lenses [Fig. 5] or
- Substrate (20) / inventive hybrid material (30) comprising additional scattering elements (SE) / transparent electrode (EL) / active layer stack, e.g. OLED emitter stack (AL); thus acting as a light extraction layer [Fig. 6].

In a further embodiment, the inventive hybrid material may be used as Bragg reflectors or anti reflecting coatings, as outlined in Fig. 4. In combination with a material of low refractive index (LRI) the inventive hybrid material (30) of the present invention provides for an intermediate acting as a Bragg reflector or anti reflection coating. This property may be achieved by stacking alternating layers of low refractive index (LRI) and high refractive index (30) material and accurately choosing the film thicknesses. Such multilayer stack may be tuned to reflect certain desired parts of the light spectrum while transmitting the others. In this embodiment, the low refractive index layer (LRI) may be composed of a porous silica nanoparticle structure. Accordingly, the invention also provides for intermediates as described herein having Anti-reflecting properties or having properties of a Bragg reflector.

Consequently, the invention also provides for an intermediate good comprising a substrate (20) coated with at least one coating (30) as described herein.

Device (40): The intermediate goods (10) described herein may find application in a wide variety of devices (40), including devices containing a display (41), devices that emit light (42), fenestration and products containing an optical authentication element (43), optical lenses. Due to the wide variety of polymer matrices possible, an extremely large variety of devices are now available. This is considered a significant advantage of the present hybrid materials, as customer-specific materials may be provided, tailored to the specific needs of the intended application.

Devices containing a display, such as an OLED according to Fig. 3A or 3B, are known and include computer monitors, TV Screens, hand-held electronic devices (watches, mobile phones, smart phones, tablet computers, navigation systems).

Devices that emit light, such shown in Fig. 3A or 3B, are known and include illuminants for space lighting. Such illuminants may be planar or non-planar and may include organic LED (OLED) or inorganic LED technology. Fenestration includes windows and doors, both in buildings and in furniture.

Products containing an optical authentication element are known and include bank notes, credit cards, tickets, vouchers, blisters (e.g. for pharmaceuticals and contact lenses) and packages (e.g. for high value products such as fragrances, pharmaceuticals).

In an advantageous embodiment of the devices according to Fig. 3A or 3B, the electrode is ITO, the hybrid material exhibits a refractive index of 1.75 - 1.95 and a mean film thickness of 1 - 20 micron.

In a **third aspect,** the invention relates to a process for manufacturing hybrid materials, coatings, intermediate goods as described herein.

As a key benefit, the intermediate goods are available through an all-solution-process. The hybrid materials are readily applicable to substrates. As a further benefit, a long lifetime (e.g. shelf life more than 1 month) of the starting material (specifically the suspensions as described below, forth aspect) was achieved. This allows for excellent up-scaling and commercialization possibilities of the materials described herein.

This aspect of the invention shall be explained in further detail below:

In one embodiment, the invention provides for a method for manufacturing a hybrid material as defined herein, comprising the steps of providing a suspension as defined below; removing the organic solvent (4), optionally by the aid of reduced pressure and / or heat; optionally curing the thus obtained material.

In one embodiment, the invention provides for a method for manufacturing an intermediate good as described herein, comprising the steps of providing a suspension as defined below; providing a support material which is optionally coated with one or more layers; coating or printing said optionally coated support material with said suspension; optionally providing further coatings on said coated substrate; and / or optionally post - treatment of said coated support material.

Each of the individual steps outlined below are known per se, but not yet applied to the inventive materials.

In a **forth aspect,** the invention relates to a suspension, said suspension particularly useful for the manufacturing of hybrid materials as described herein. As a key benefit, the suspensions described herein show good shelf life and are readily applicable to a substrate by using conventional coating techniques.

This aspect of the invention shall be explained in further detail below:

In one embodiment, the invention , as defined in claim 11, provides for a suspension (5) comprising 0.5-80 wt-%,

preferably 2-50 wt-%, most preferably 5-30 wt-% nanoparticles (1) as described herein; 0.01-20 wt-%, preferably 0.1-5 wt-%, most preferably 0.5-2 wt-% surfactants (2) as described herein; 0.09-99 wt-%, preferably 0.5-49 wt-%, most preferably 1-10wt-% matrix molecule (3) as described herein; 0-99 wt-%, preferably 45-90 wt-%, most preferably, 65-85 wt-% solvent (4) selected from the group of water, alcohols, glycol-ethers, ketones, and aprotic polar solvents.

As indicated above, the amount of solvents may be low or even zero. In the case of low solvent amounts, the matrix molecule also acts as a solvent phase.

Solvents (4): It was found that five classes of solvents show very beneficial effects, namely: water, alcohols, glycol-ethers, ketones, and aprotic polar solvents. This also includes combinations of two or more of such solvents.

These solvents are explained in further detail below.

Advantageously, said alcohols are of formula (IIX)

$R_{12}$-OH (IIX)

wherein $R_{12}$ represents C1-8 alkyl. Preferred alcohols are selected from the group of methanol, ethanol, isopropanol, propanol, and butanol.

Advantageously, said glycol-ethers are of the formula (IX-I) or (IX-II):

HO-$R_9$-O-$R_{11}$ (IX-I),

HO-$R_9$-O-$R_{10}$-O-$R_{11}$ (IX-II)

whereby $R_9$ is $C_nH_{2n}$, (n = 1-4),
whereby $R_{10}$ is CnH2n, (n = 1-4),
whereby $R_{11}$ is $C_mH_{2m}CH_3$ (m = 0-4) .

Most advantageously, said glycol ether is Propoxy-ethanol.

Suitable ketones are known in the field. Advantageously, said ketones are acetone and MEK.

Suitable aprotic polar solvents are known in the field. Advantageously, said aprotic polar solvents are preferably selected from the group of dimethyl sulfoxide (DMSO), N-methyl pyrrolidone, dimethyl formamide, dimethyl acetamide (DMAC), and gamma butyrolacetone. Particularly preferred aprotic polar solvents are DMSO and DMAC.

To further illustrate the invention, the following **examples** are provided. These examples are provided with no intent to limit the scope of the invention. Experiments 1-14 are not part of the invention and are for reference only.

Experiment 1

Strontium titanate ($SrTiO_3$) nanoparticles were synthesized by flame spray synthesis. For the preparation of the precursor, 90.6g Sr-acetate (ABCR) was added to 679g 2-ethylhexanoic acid and dissolved by heating the mixture for 1 hour at 150°C. 125.2g Ti-isopropoxide (Aldrich) was added after cooling down to room temperature. The obtained solution was diluted with THF 7.5:4.5 by weight. The precursor then was fed (9 ml $min^{-1}$, HNP Mikrosysteme, micro annular gear pump mzr-2900) to a spray nozzle, dispersed by oxygen (6 1 $min^{-1}$, PanGas tech.) and ignited by a premixed methane-oxygen flame ($CH_4$: 1.2 1 $min^{-1}$, $O_2$: 2.2 1 $min^{-1}$). The off-gas was filtered through a glass fiber filter (Schleicher & Schuell) by a vacuum pump (Busch, Seco SV1040CV) at about 20 $m^3$ $h^{-1}$. The obtained oxide nanopowder was collected from the glass fiber filter.

The mean crystallite size was measured with a Rigaku MiniFlex 600, an SC-70 Detector, measured from 10° to 70° at 0.01° step size by using the Scherrer equation. The mean crystallite size of the SrTiO3 particles was 21 nm. For the preparation of suspensions, 10 wt-% of nanopowder (as described above), 0.5 wt-% of 2-[2-(2-Methoxyethoxy)ethoxy]acetic acid (Aldrich) and 89.5 wt-% of ethylene glycol monopropyl ether (Sigma Aldrich) was dispersed by ball-milling for 2 h. The finally prepared suspension is transparent and stable for more than 3 months. To 93.6 wt-% of this first suspension, 2.4 wt-% of Bis(4-methacryloylthiophenyl) Sulfide (TCI-Chemicals) and 4 wt% of a premixed solution of 2-Hydroxy-2-methyl-propiophenone (Sigma Aldrich) 5 wt-% in ethylene glycol monopropyl ether (Sigma Aldrich) were added and thoroughly mixed. The finally prepared suspension is transparent but only stable for a few hours due to degradation of the monomer.

This second suspension was spin coated onto a glass substrate at 1000 rpm for 45s and UV cured for 5 min under a commercially available UV lamp (36 watts, 365nm). The result was a transparent film, showing the typical interference colors of films in thickness range of the visible light spectrum.

The properties of the achieved film were measured with a Filmetrics F-10-RT-UV reflectometer. A film thickness of 150 nm and a refractive index of 1.90 were measured at these conditions.

Experiment 2

Strontium titanate ($SrTiO_3$) nanoparticles were synthesized by flame spray synthesis. For the preparation of the precursor, 90.6g Sr-acetate (ABCR) was added to 679g and 2-ethylhexanoic acid and dissolved by heating the mixture for 1 hour at 150°C. 125.2g Ti-isopropoxide (Aldrich) was added after cooling down to room temperature. The obtained solution was diluted with THF 7.5:4.5 by weight. The precursor then was fed (7 ml $min^{-1}$, HNP Mikrosysteme, micro annular gear pump mzr-2900) to a spray nozzle, dispersed by oxygen (15 1 $min^{-1}$, PanGas tech.) and ignited by a premixed methane-oxygen flame ($CH_4$: 1.2 1 $min^{-1}$, $O_2$: 2.2 1 $min^{-1}$). The off-gas was filtered through a glass fiber filter (Schleicher & Schuell) by a vacuum pump (Busch, Seco SV1040CV) at about 20 $m^3$ $h^{-1}$. The obtained oxide nanopowder was collected from the glass fiber filter.

The mean crystallite size was measured with a Rigaku MiniFlex 600, an SC-70 Detector, measured from 10° to 70° at 0.01° step size by using the Scherrer equation. The mean crystallite size of the SrTiO3 particles was 13 nm.

For the preparation of suspensions, 25 wt-% of nanopowder (as described above), 1.25 wt-% of 2-[2-(2-Methoxyethoxy)ethoxy]acetic acid (Aldrich) and 73.75 wt% of ethylene glycol monopropyl ether (Sigma Aldrich) was dispersed by ball-milling for 2 h. The finally prepared suspension is transparent and stable for more than 3 months.

The hydrodynamic particle size was determined by a gravitational analysis technique (Lumisizer 610, 2mm polycarbonate cuvette, Volume-weighted distribution):
The hydrodynamic particle size was determined as:

D10 = 9.3nm
D50 = 11.9nm
D90 = 17.3nm
D99 = 28.2nm

To 44.4 wt-% of this first suspension, 2.8 wt-% of O-phenylphenoxy ethyl acrylate (Jobachem), 2.8 wt-% of a premixed solution of 2-Hydroxy-2-methylpropiophenone (Sigma Aldrich) 5 wt-% in ethylene glycol monopropyl ether (Sigma Aldrich) and 50 wt-% ethylene glycol monopropyl ether (Sigma Aldrich) were added and thoroughly mixed. The finally prepared suspension is transparent and stable for more than 3 months if not subjected to UV radiation.

This second suspension was spin coated onto a glass substrate at 3500 rpm for 45s and UV cured for 5 min under a commercially available UV lamp (36 watts, 365nm). The result was a transparent film, showing the typical interference colors of films in thickness range of the visible light spectrum.

The properties of the achieved film were measured with a Filmetrics F-10-RT-UV reflectometer. A film thickness of 120 nm and a refractive index of 1.83 were measured at these conditions.

Experiment 3

To 89.9 wt-% of the first suspension from Experiment 2, 1.3 wt-% of polyvinylpyrrolidone K90 (Ashland) was added and slowly dissolved by rigorously stirring at 65°C. The result was a highly viscous suspension. To this 4.4 wt-% of Bis(4-methacryloylthiophenyl) Sulfide (TCI-Chemicals) and 4.4 wt-% of a premixed solution of 2-Hydroxy-2-methylpropiophenone (Sigma Aldrich) 5 wt-% in ethylene glycol monopropyl ether (Sigma Aldrich) were added and thoroughly mixed. The finally prepared suspension is transparent, highly viscous but only stable for a few hours due to degradation of the monomer.

This second suspension was spin coated onto a glass substrate at 1000 rpm for 45s and UV cured for 5 min under a commercially available UV lamp (36 watts, 365nm). The result was a thick transparent film, with no cracks or haze recognizable by visual inspection.

The properties of the achieved film were measured with a Filmetrics F-10-RT-UV reflectometer. A film thickness of 3700 nm and a refractive index of 1.83 were measured at these conditions.

Experiment 4

The final suspension from experiment 3 was spin coated onto a glass substrate at 250 rpm for 45s and UV cured for 5 min under a commercially available UV lamp (36 watts, 365nm). The result was a very thick transparent film, with no cracks or haze recognizable by visual inspection.

The properties of the achieved film were measured with a Filmetrics F-10-RT-UV reflectometer. A film thickness of 17160 nm was measured at these conditions. Due to limitation of the measurement device, no refractive index could be determined but it can be strongly assumed that it is similar to the thinner film shown in experiment 3. The averaged reflection plus transmission between 550nm and 650nm was measured with the same device to be 97.6%, therefore corresponding to a value of absorption plus scattering lower than 2.4%

Experiment 5

For the preparation of suspensions, 25 wt-% of nanopowder (as described above), 1.25 wt-% of phosphate ester of alkyl ethers of formula (IV) and 73.75 wt-% of ethylene glycol monopropyl ether (Sigma Aldrich) was dispersed by ball-milling for 2 h. The finally prepared suspension is translucent and stable for more than 3 months.

To 44.4 wt-% of this first suspension, 2.8 wt-% of O-phenylphenoxy ethyl acrylate (Jobachem), 2.8 wt-% of a premixed solution of 2-Hydroxy-2-methylpropiophenone (Sigma Aldrich) 5 wt-% in ethylene glycol monopropyl ether (Sigma Aldrich) and 50 wt-% ethylene glycol monopropyl ether (Sigma Aldrich) were added and thoroughly mixed. The finally prepared suspension is transparent and stable for more than 3 months if not subjected to UV radiation.

This second suspension was spin coated onto a glass substrate at 3500 rpm for 45s and UV cured for 5 min under a commercially available UV lamp (36 watts, 365nm). The result was a transparent film, showing the typical interference colors of films in thickness range of the visible light spectrum.

The properties of the achieved film were measured with a Filmetrics F-10-RT-UV reflectometer. A film thickness of 280 nm and a refractive index of 1.82 were measured at these conditions.

Experiment 6

For the preparation of suspensions, 25 wt-% of nanopowder from experiment 2, 1.2 wt-% of 2-[2-(2-Methoxyethoxy)ethoxy]acetic acid (Aldrich), 7.4 wt-% of ethylene glycol monopropyl ether (Sigma Aldrich) and 66.4 wt-% dimethyl sulfoxide (Acros) was dispersed by ball-milling for 1 h. The finally prepared suspension is transparent and stable for more than 3 months.

To 61.5 wt-% of this first suspension, 38.5 wt-% of a premixed solution of polyethersulfone (Veradel) 10 wt-% in dimethyl sulfoxide (Acros) were added and thoroughly mixed. The finally prepared suspension is transparent and stable for more than 3 months.

This second suspension was spin coated under nitrogen atmosphere onto a glass substrate at 3500 rpm for 45s and dried at 80°C. The result was a transparent film, showing the typical interference colors of films in thickness range of the visible light spectrum. The resulting film was resistant to thermal degradation up to 250°C.

The properties of the achieved film were measured with a Filmetrics F-10-RT-UV reflectometer. A film thickness of 360 nm and a refractive index of 1.86 were measured at these conditions.

Experiment 7

To 70.6 wt-% of the first suspension of experiment 6, 29.4 wt-% of a premixed solution of polyethersulfone (Veradel) 15 wt-% in dimethyl sulfoxide (Acros) were added and thoroughly mixed. The finally prepared suspension is transparent and stable for more than 3 months.

This final was spin coated under nitrogen atmosphere onto a glass substrate at 200 rpm for 45s and dried at 80°C. The result was a very thick transparent film, with no cracks or haze visibly by visual inspection.

The properties of the achieved film were measured with a Filmetrics F-10-RT-UV reflectometer. A film thickness of 2500 nm and a refractive index of 1.87 were measured at these conditions. The averaged reflection plus transmission between 550nm and 650nm was measured with the same device to be 100.0%, therefore corresponding to a value of absorption plus scattering lower than 0.1%

Experiment 8

To 44.4 wt-% of the first suspension of Experiment 2, 2.8 wt-% of Sartomer CN2302 (Sartomer), 2.8 wt-% of a premixed solution of 2-Hydroxy-2-methylpropiophenone (Sigma Aldrich) 5 wt-% in ethylene glycol monopropyl ether (Sigma Aldrich) and 50 wt-% ethylene glycol monopropyl ether (Sigma Aldrich) were added and thoroughly mixed. The finally prepared suspension is transparent and stable for more than 3 months if not subjected to UV radiation.

This second suspension was spin coated onto a glass substrate at 1000 rpm for 45s and UV cured for 5 min under a commercially available UV lamp (36 watts, 365nm). The result was a thick transparent film, with no cracks or haze visibly by visual inspection.

The properties of the achieved film were measured with a Filmetrics F-10-RT-UV reflectometer. A film thickness of 2500 nm and a refractive index of 1.78 were measured at these conditions.

Experiment 9

To 44.4 wt-% of the first suspension of Experiment 2, 1.4 wt-% of UHU Plus Schnellfest 2-component epoxy-adhesive binder (UHU), 1.4 wt-% of UHU Plus Schnellfest 2-component epoxy-adhesive hardener (UHU), 52.8 wt-%

ethylene glycol monopropyl ether (Sigma Aldrich) were added and thoroughly mixed. The finally prepared suspension is transparent but only stable for a few minutes because of reaction of the two components.

This second suspension was spin coated onto a glass substrate at 500 rpm for 5min and UV cured for 5 min at 80°C. The result was a thick transparent film, with no cracks or haze visibly by visual inspection.

The properties of the achieved film were measured with a Filmetrics F-10-RT-UV reflectometer. A film thickness of 3500 nm and a refractive index of 1.83 were measured at these conditions.

Experiment 10

For the preparation of suspensions, 25 wt-% of nanopowder from experiment 2, 5 wt-% of 2-[2-(2-Methoxyethoxy)ethoxy] acetic acid (Aldrich) and 70 wt-% of acetone (Sigma Aldrich) was dispersed by ball-milling for 2 h. The finally prepared suspension is transparent and stable for more than 3 months.

To 89.3 wt-% of this first suspension 10.7 wt-% of hydroxyethyl methacrylate (Sigma Aldrich) was added and thoroughly mixed. Of the resulting suspension the acetone was removed by rotary evaporation at room temperature and 100mbar.

The final suspension was transparent, highly viscous but still processable and had a $SrTiO_3$ loading of 64 wt%.

Experiment 11

Commercially available titanium dioxide ($TiO_2$), rutile phase particles were purchased from SRX Korea. The mean crystallite size was measured with a Rigaku MiniFlex 600, an SC-70 Detector, measured from 10° to 70° at 0.01° step size by using the Scherrer equation. The mean crystallite size of the $TiO_2$ particles was 37.6 nm.

For the preparation of the suspensions, 13.89 wt-% of nanopowder (as described above), 3.47 wt-% of 2-[2-(2-Methoxyethoxy)ethoxy]acetic acid (Aldrich) and 82.64 wt-% of ethylene glycol monopropyl ether (Sigma Aldrich) was dispersed by ball-milling for 2 h. The finally prepared suspension is translucent due to too large starting particles and stable for more than 1 day.

This suspension was spin coated onto a glass substrate at 2500 rpm for 45s. The result was a transparent, slightly cloudy film, showing the typical interference colors of films in thickness range of the visible light spectrum.

The properties of the achieved film were measured with a Filmetrics F-10-RT-UV reflectometer. A film thickness of 210 nm and a refractive index of 1.91 were measured at these conditions.

Experiment 12

The same particles as described in experiment 11 were used for this experiment.

For the preparation of the suspensions, 16.39 wt-% of nanopowder (as described above), 0.82 wt-% of 2-[2-(2-Methoxyethoxy)ethoxy]acetic acid (Aldrich), 8.20 wt-% of ethanol (Fluka) and 74.59 wt-% of water (Fluka) was dispersed by ball-milling for 2 h.

To 70.62 wt-% of this first suspension, 29.38 wt-% of previously dissolved PVP-K90 (Ashland) solution (10 wt-% in water) was added and well mixed. The finally prepared suspension is translucent due to too large starting particles and stable for more than 1 day.

This final suspension was spin coated onto a glass substrate at 3500 rpm for 45s. The result was a transparent, slightly cloudy film, showing the typical interference colors of films in thickness range of the visible light spectrum.

The properties of the achieved film were measured with a Filmetrics F-10-RT-UV reflectometer. A film thickness of 360 nm and a refractive index of 1.94 were measured at these conditions.

Experiment 13

Commercially available titanium dioxide ($TiO_2$), anatase phase particles were purchased from Kronos International Inc. The product KronoClean 7050 was specified to be of pure anatase phase with 15nm particle size. The mean crystallite size was measured with a Rigaku MiniFlex 600, an SC-70 Detector, measured from 10° to 70° at 0.01° step size by using the Scherrer equation. The mean crystallite size of the $TiO_2$ particles was 6.6 nm.

For the preparation of suspensions, 14.7 wt-% of nanopowder (as described above), 3.5 wt-% of 2-[2-(2-Methoxyethoxy)ethoxy]acetic acid (Aldrich) and 81.8 wt-% of ethylene glycol monopropyl ether (Sigma Aldrich) was dispersed by ball-milling for 5 h. The finally prepared suspension is translucent and stable for more than 1 day.

Two grams of this first suspension were dried at 110°C and analyzed with a Rigaku MiniFlex 600, an SC-70 Detector, measured from 10° to 70° at 0.01° step size. The mean crystallite size, as calculated by the Scherrer equation, was reduced to 5.1nm, while the peak-to-background ratio was reduced from 10 for the original powder to 5 for the processed and dried powder, thus implicating a strong amorphisation of the Ti02 particles.

This suspension was spin coated onto a glass substrate at 3500 rpm for 45s. The result was a transparent film, showing the typical interference colors of films in thickness range of the visible light spectrum.

The properties of the achieved film were measured with a Filmetrics F-10-RT-UV reflectometer. A film thickness of 180 nm and a refractive index of 1.82 were measured at these conditions.

Experiment 14

To 38.10 wt-% of the first suspension of Experiment 2, 23.80 wt-% of a premixed solution of Polyvinylbutyral (Kuraray) 10 wt-% in ethylene glycol monopropyl ether (Sigma Aldrich) and 38.10 wt-% ethylene glycol monopropyl ether (Sigma Aldrich) were added and thoroughly mixed. The finally prepared suspension is transparent and stable for more than 3 months.

This second suspension was spin coated onto a glass substrate at 1000 rpm for 45s. The result was a transparent film, showing the typical interference colors of films in thickness range of the visible light spectrum.

The properties of the achieved film were measured with a Filmetrics F-10-RT-UV reflectometer. A film thickness of 340 nm and a refractive index of 1.76 were measured at these conditions.

Experiment 15

Commercially available rutile(TiO2)/Al2O3 core/shell particles were purchased from Sachtleben. The product Hombitec RM 110 was specified to have 12nm particle size. The mean crystallite size was measured with a Rigaku MiniFlex 600, an SC-70 Detector, measured from 10° to 70° at 0.01° step size by using the Scherrer equation. The mean crystallite size of the TiO2 particles was 14.6 nm.

For the preparation of suspensions, 25 wt-% of nanopowder (as described above), 2.5 wt-% of 2-[2-(2-Methoxyethoxy)ethoxy]acetic acid (Aldrich) and 72.5 wt-% of ethylene glycol monopropyl ether (Sigma Aldrich) was dispersed by ball-milling for 2 h. The finally prepared suspension is milky and stable for more than 1 day.

To 45.4 wt-% of this first suspension, 2.3 wt-% of O-phenylphenoxy ethyl acrylate (Jobachem), 2.3 wt-% of a premixed solution of 2-Hydroxy-2-methylpropiophenone (Sigma Aldrich) 5 wt-% in ethylene glycol monopropyl ether (Sigma Aldrich) and 50 wt-% ethylene glycol monopropyl ether (Sigma Aldrich) were added and thoroughly mixed. The finally prepared suspension is translucent and stable for more than 1 day if not subjected to UV radiation.

This final suspension was spin coated onto a glass substrate at 1000 rpm for 45s and UV cured for 5 min under a commercially available UV lamp (36 watts, 365nm). The result was a transparent film, showing the typical interference colors of films in thickness range of the visible light spectrum.

The properties of the achieved film were measured with a Filmetrics F-10-RT-UV reflectometer. A film thickness of 250 nm and a refractive index of 1.86 were measured at these conditions.

Experiment 16

The rutile (TiO2)/Al2O3 core/shell particles described in experiment 15 and commercially available anatase TiO2 particles (KronosTi02 Kronoclean 7050) were processed into suspensions as follows:
10 wt-% of nanopowder (as described above), 2 wt-% of 2-[2-(2-Methoxyethoxy)ethoxy]acetic acid (Aldrich) and 88 wt-% of ethylene glycol monopropyl ether (Sigma Aldrich) was dispersed by ball-milling for 15min. The finally prepared suspension is stable for several hours.

To 4g of each of the first suspensions 0.1g of O-phenylphenoxy ethyl acrylate (Jobachem) and 0.1g of a premixed solution of 2-Hydroxy-2-methylpropiophenone (Sigma Aldrich) 5 wt-% in ethylene glycol monopropyl ether (Sigma Aldrich) were added and thoroughly mixed. These final suspensions were spin coated onto a glass substrate at 1000rpm for 1 minute and subsequently UV-cured under a commercially available UV lamp (Hönle UVA Cube 100) for 1 minute (anatase) or 5 minutes (rutile/Al2O3 core-shell) respectively, leading to films of approximately 200nm.

These cured layers were tested for refractive index with a Filmetrics F-10-RT-UV reflectometer. The mechanical stability was determined by a commercially available manual pencil hardness test. The films were then UV aged in the above mentioned UV lamp for 6 hours. The following results were obtained:

| Material | stability under UV / ambient | mechanical stability | refractive index |
|---|---|---|---|
| rutile/Al2O3 core-shell | very good: no yellowing | good: pencil hardness HB | 1.88 |
| anatase | poor: yellowing after 5min of UV treatment | good: pencil hardness HB | 1.82 |

As this experiment shows, the inventive composites show high refractive index in combination with very good

mechanical stability. When using nanoparticles according to ex. 15, also UV stability is significantly improved while maintaining high mechanical stability and high refractive index.

## Claims

1. A solid hybrid material (30) comprising

   - 50-90 wt-% nanoparticles (1) selected from the group of titanates;
   - 1-20 wt-% surfactants (2) selected from the group of monocarboxylic acids comprising a polyether tail and phosphate esters of alkyl ethers;
   - 9-49 wt-% polymeric matrix (3) selected from the group of acrylate polymers, sulfone polymers, epoxy polymers, vinyl polymers, urethane polymers and imide polymers,

   **characterized in that**

   - the nanoparticles are of a core-shell structure and the core and the shell are composed of different oxides, and
   - the nanoparticle's core is composed of titanates according to formula (I),

   $$M_xTi_yO_z \qquad (I),$$

   wherein:

   M represents alkaline- or alkaline earth metal,
   x represents 0, a real number below 1 or 1,
   y represents 1 or, a real number below 1 but excluding 0,
   z represents a real number below 1 but excluding 0,

   provided that:

   z=x/2+2*y if M represents an alkaline metal or
   z=x+2*y if M represents an alkaline earth metal or
   z=2*y if x=0; and

   - the material preferably shows a refractive index >1.75; and
   - the nanoparticle's shell preferably amounts to less than 20 wt-% (based on oxide weight) of the whole nanoparticle.

2. The hybrid material according to claim 1, wherein the nanoparticles (1) are of a core-shell structure, whereby

   - the core is a titanate as defined in claim 1 and the shell is Al2O3; and
   - the shell preferably amounts to less than 20 wt-% (based on oxide weight) of the whole particle.

3. The hybrid material according to any of claims 1 to 2, wherein the titanate is a rutile type TiO2.

4. The hybrid material according to any of claims 1 to 3, comprising 75-85 wt-% nanoparticles (1).

5. The hybrid material according to any of claims 1 - 4,
   wherein said surfactant is a monocarboxylic acid of formula (II),

   $$R(OC_nH_{2n})_qOCH_2C(O)OH \qquad (II),$$

   wherein

   R is $C_{1-5}$-alkyl,
   q is an integer from 0 to 5,
   n is an integer from 1 to 3; or

wherein said surfactant is a phosphate ester of an alkyl ether wherein the alkyl ether is of formula (IV),

$$R_4O\text{-}(C_2H_4O)_m(C_3H_6O)_n\text{-} \qquad \text{(IV)},$$

wherein

R4 is $C_{1\text{-}10}$-alkyl;
m is an integer from 2 to 60;
n is an integer from 2 to 60.

**6.** The hybrid material according to any of claims 1 - 5,
wherein the acrylate polymers are obtained from monomers of formula (V-I) or (V-II)

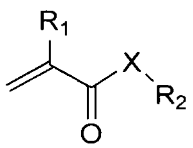
(V-I),
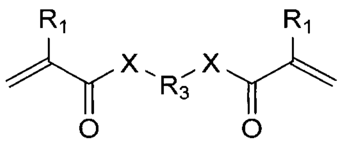
(V-II)

wherein

$R_1$ independently represents hydrogen or methyl;
X independently represents oxygen or sulphur;
$R_2$ represents a substituent selected from phenyl, phenyl-$C_{1\text{-}4}$ alkyl, phenyl-oxy and phenyl-oxy-$C_{1\text{-}4}$ alkyl; said phenyl optionally being substituted by 1-3 substituents selected from the group of C1-4 alkyl, phenyl, halogen, hydroxyl,
$R_3$ represents a substituent selected from phenyl, diphenyl (Ph-Ph), diphenylsulfyl (Ph-S-Ph), diphenyloxy (Ph-O-Ph),
said phenyl optionally being substituted by 1-3 substituents selected from the group of $C_{1\text{-}4}$ alkyl, phenyl, halogen, hydroxy;

wherein the sulfone polymers have repeating units of formula (VI),

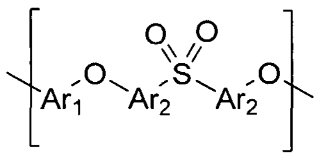
(VI),

wherein

$Ar_1$ represents phenyl, a phenylether, a phenylthio-ether, a bisphenol,
said phenyl optionally being substituted by 1-3 substituents selected from the group of C1-4 alkyl, phenyl, halogen, hydroxyl,
$Ar_2$ represents phenyl,
said phenyl optionally being substituted by 1-3 substituents selected from the group of C1-4 alkyl, phenyl, halogen, hydroxy;

wherein the vinyl polymer comprises repeating units of formula (VII)

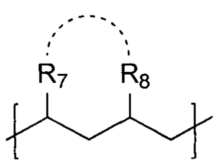
(VII)

wherein:

$R_7$ represents hydrogen, $C_{1-4}$ alkyl, hydroxy, cyano, 2-pyrrolidone,
$R_8$ represents hydroxy, cyano, 2-pyrrolidone; or wherein:

$R_7$, $R_8$ together form a heterocycle,
said heterocycle being selected from 1,3-dioxanes,
said heterocycle optionally being substituted by 1-3 $C_{1-8}$ alkyl groups.

**7.** The hybrid material according to any of claims 1 to 6 in the form of a thin layer or in the form of micro lenses,

- said layer having a thickness of 30 nm - 100 μm; and / or
- said micro lenses having a diameter of 1 - 500 μm; and / or
- said nanoparticles having a size of 5 - 30 nm.

**8.** An intermediate good (10) comprising a substrate (20) coated with at least one layer (30) as defined in claim 7.

**9.** The intermediate good according to claim 8, having the following (bottom-up) structure:

- Substrate (20) / hybrid material (30) according to any of claims 1 - 6 / transparent electrode (EL) / active layer stack e.g. OLED emitter stack (AL) acting as an index matching layer; or
- Substrate (20) / hybrid material (30) according to any of claims 1 - 6 / transparent electrode (EL) / active layer stack e.g. OLED emitter stack (AL) acting as a light extraction layer; or
- having the following (bottom-up) structure: Substrate (20) / multiple units of low refractive index layer (LRI) and hybrid material (30) according to any of claims 1 - 6 or substrate (20) / multiple units of the hybrid material (30) according to any of claims 1 - 6 and low refractive index layer (LRI); or
- substrate (20) / hybrid material (30) according to any of claims 1 - 6 in the form of microlenses; or
- Substrate (20) / hybrid material (30) according to any of claims 1 - 6 comprising additional scattering elements (SE) / transparent electrode (EL) / active layer stack e.g. OLED emitter stack (AL)acting as a light extraction layer.

**10.** A device comprising the intermediate good according to claim 8 or 9, the device selected from the group consisting of

- devices containing a display,
- devices that emit light,
- fenestration, and
- products containing an optical authentication element.

**11.** A suspension (5) comprising

- 0.5 - 80 wt-% nanoparticles (1) as defined in claim 1 to 3 ;
- 0.01 - 20 wt-% surfactants (2) as defined in claim 5;
- 0.09 - 99 wt-% polymeric matrix (3) as defined in claim 1 or 6;
- 0 - 99 wt-% organic solvent (4) selected from the group of water, alcohols, glycol-ethers, ketones, and aprotic polar solvents.

**12.** The suspension of claim 11, wherein

- said alcohols are selected from the group of methanol, ethanol, isopropanol, propanol, and butanol;
- said glycol-ether is Propoxy-ethanol;
- said ketones are selected from acetone and MEK;
- said aprotic polar solvents are selected from dimethyl sulfoxide, N-methyl pyrrolidone, dimethyl formamide, dimethyl acetamide.

**13.** A method for manufacturing a suspension according to claims 11 or 12, said method comprising the steps of

- combining an organic solvent (4) selected from the group of water , alcohols , glycol-ethers , ketones , and aprotic polar solvents, the nanoparticles (1) as defined in claims 1-4 and the surfactants (2) as defined in claim 5 to obtain a first suspension;

- combining said organic solvent (4) and the polymer matrix (3) as defined in claim 1 or 6 to obtain a first solution;
- combining said first suspension and said first solution to obtain the suspension.

**14.** A method for manufacturing a hybrid material according to any of claims 1 - 6, said method comprising the steps of

- providing a suspension according to any of claims 11 or 12;
- removing the organic solvent (4), optionally by the aid of reduced pressure and / or heat;
- optionally curing the thus obtained material.

**15.** A method for manufacturing an intermediate good according to any of claims 8 - 9, said method comprising the steps of

- providing a suspension according to any of claims 11 or 12;
- providing a support material which is optionally coated with one or more layers;
- coating / printing said optionally coated support material with said suspension;
- optionally providing further coatings on said coated substrate; and / or
- optionally post - treatment of said coated support material.

**Patentansprüche**

**1.** Ein festes Hybridmaterial (30), umfassend

- 50-90 Gew.-% Nanopartikel (1), ausgewählt aus der Gruppe der Titanate;
- 1-20 Gew.-% Tenside (2), ausgewählt aus der Gruppe der Monocarbonsäuren, die einen Polyetherschwanz und Phosphatester von Alkylethern umfassen;
- 9-49 Gew.-% Polymermatrix (3), ausgewählt aus der Gruppe der Acrylatpolymere, Sulfonpolymere, Epoxidpolymere, Vinylpolymere, Urethanpolymere und Imidpolymere,

**dadurch gekennzeichnet, dass**

- die Nanopartikel eine Kern-Schalen-Struktur haben und der Kern und die Schale aus verschiedenen Oxiden zusammengesetzt sind, und
- die Nanopartikel Titanate der Formel (I) sind,

$$M_xTi_yO_z \qquad (I),$$

wobei:

M ein Alkali- oder Erdalkalimetall darstellt,
x 0, eine reelle Zahl unter 1 oder 1 darstellt,
y 1 oder eine reelle Zahl kleiner als 1, jedoch unter Ausschluss von 0 darstellt,
z eine reelle Zahl unter 1, jedoch unter Ausschluss von 0 darstellt,
vorausgesetzt, dass:

z=x/2+2*y, wenn M ein Alkalimetall darstellt oder
z=x+2*y, wenn M ein Erdalkalimetall darstellt, oder
z=2*y, wenn x=0; und

- das Material bevorzugt einen Brechungsindex >1.75 hat; und
- die Schale des Nanopartikels vorzugsweise weniger als 20 Gew.-% (bezogen auf das Oxidgewicht) des gesamten Nanopartikels ausmacht.

**2.** Das Hybridmaterial nach Anspruch 1, wobei die Nanopartikel (1) eine Kern-Schale-Struktur aufweisen, wobei

- der Kern ein Titanat gemäss Anspruch 1 ist und die Schale Al2O3 ist; und
- die Schale vorzugsweise weniger als 20 Gew.-% (bezogen auf das Oxidgewicht) des gesamten Partikels ausmacht.

3. Hybridmaterial nach einem der Ansprüche 1 bis 2, wobei das Titanat ein TiO2 vom Rutiltyp ist.

4. Das Hybridmaterial nach einem der Ansprüche 1 bis 3, umfassend 75-85 Gew.-% Nanopartikel (1) .

5. Das Hybridmaterial nach einem der Ansprüche 1 bis 4, wobei das Tensid eine Monocarbonsäure der Formel (II) ist,

$R(OC_nH_{2n})_qOCH_2C(O)OH$ (II),

wobei

R $C_{1-5}$-Alkyl ist,
q eine ganze Zahl von 0 bis 5 ist,
n eine ganze Zahl von 1 bis 3 ist; oder

wobei das Tensid ein Phosphatester eines Alkylethers ist, wobei der Alkylether die Formel (IV) hat,

$R_4O$- $(C_2H_4O)m(C_3H_6O)$ n- (IV),

worin

$R_4$ $C_{1-10}$-Alkyl ist;
m eine ganze Zahl von 2 bis 60 ist;
n eine ganze Zahl von 2 bis 60 ist.

6. Das Hybridmaterial nach einem der Ansprüche 1 - 5, wobei die Acrylatpolymere aus Monomeren der Formel (V-I) oder (V-II) erhalten werden

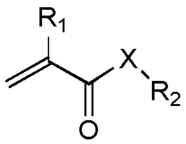 (V-I), 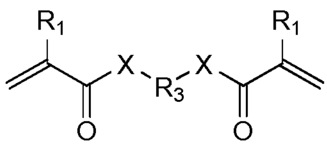 (V-II)

wobei

$R_1$ unabhängig voneinander für Wasserstoff oder Methyl steht;
X unabhängig voneinander für Sauerstoff oder Schwefel steht;
$R_2$ einen Substituenten darstellt, der aus Phenyl, Phenyl-$C_{1-4}$-alkyl, Phenyloxy und Phenyloxy-$C_{1-4}$-alkyl ausgewählt ist;
wobei das Phenyl gegebenenfalls durch 1-3 Substituenten, ausgewählt aus der Gruppe $C_{1-4}$-Alkyl, Phenyl, Halogen, Hydroxyl, substituiert ist
$R_3$ einen Substituenten darstellt, ausgewählt aus Phenyl, Diphenyl (Ph-Ph), Diphenylsulfyl (Ph-S-Ph), Diphenyloxy (Ph-O-Ph),
wobei das Phenyl gegebenenfalls durch 1-3 Substituenten, ausgewählt aus der Gruppe $C_{1-4}$-Alkyl, Phenyl, Halogen, Hydroxy, substituiert ist;
wobei die Sulfonpolymere sich wiederholende Einheiten der Formel (VI) aufweisen,

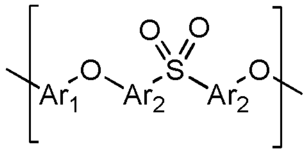 (VI),

wobei

$Ar_1$ für Phenyl, einen Phenylether, einen Phenylthioether, ein Bisphenol steht,

wobei das Phenyl gegebenenfalls durch 1-3 Substituenten, ausgewählt aus der Gruppe $C_{1-4}$-Alkyl, Phenyl, Halogen, Hydroxyl, substituiert ist,
$Ar_2$ Phenyl darstellt,
wobei das Phenyl gegebenenfalls durch 1-3 Substituenten substituiert ist, die aus der Gruppe $C_{1-4}$-Alkyl, Phenyl, Halogen, Hydroxy ausgewählt sind;
wobei das Vinylpolymer sich wiederholende Einheiten der Formel (VII) umfasst

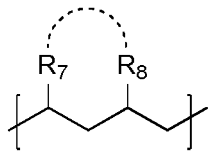

(VII)

wobei:

$R_7$ Wasserstoff, $C_{1-4}$-Alkyl, Hydroxy, Cyano, 2-Pyrrolidon darstellt,
$R_8$ Hydroxy, Cyano, 2-Pyrrolidon darstellt; oder wobei:
$R_7$, $R_8$ zusammen einen Heterozyklus bilden, wobei der Heterocyclus ausgewählt ist aus 1,3-Dioxanen, wobei der Heterozyklus gegebenenfalls durch 1-3 $C_{1-8}$-Alkylgruppen substituiert ist.

**7.** Das Hybridmaterial nach einem der Ansprüche 1 bis 6 in Form einer dünnen Schicht oder in Form von Mikrolinsen, wobei die Schicht eine Dicke von 30 nm - 100 µm aufweist; und / oder
wobei die Mikrolinsen einen Durchmesser von 1 - 500 µm aufweisen; und / oder
wobei die Nanopartikel eine Grösse von 5 - 30 nm haben.

**8.** Ein Zwischenprodukt (10) umfassend ein Substrat (20), das mit mindestens einer Schicht (30) wie in Anspruch 7 definiert beschichtet ist.

**9.** Das Zwischenprodukt nach Anspruch 8 mit folgendem Aufbau (von unten nach oben):

- Substrat (20) / Hybridmaterial (30) nach einem der Ansprüche 1 - 6 / transparente Elektrode (EL) / aktiver Schichtstapel z.B. OLED-Emitterstapel (AL), der als Indexanpassungsschicht wirkt; oder
- Substrat (20) / Hybridmaterial (30) nach einem der Ansprüche 1 - 6 / transparente Elektrode (EL) / aktiver Schichtstapel z. B. OLED-Emitterstapel (AL), der als Lichtauskopplungsschicht wirkt; oder
- mit folgendem Aufbau (von unten nach oben):
Substrat (20) / mehrere Einheiten einer Schicht mit niedrigem Brechungsindex (LRI) und Hybridmaterial (30) nach einem der Ansprüche 1 - 6 oder Substrat (20) / mehrere Einheiten des Hybridmaterials (30) nach einem der Ansprüche 1 - 6 und Schicht mit niedrigem Brechungsindex (LRI); oder
- Substrat (20) / Hybridmaterial (30) nach einem der Ansprüche 1 - 6 in Form von Mikrolinsen; oder
- Substrat (20) / Hybridmaterial (30) nach einem der Ansprüche 1 - 6 umfassend zusätzliche Streuelemente (SE) / transparenter Elektrode (EL) / aktivem Schichtstapel, z.B. OLED-Emitterstapel (AL), der als Lichtauskopplungsschicht wirkt.

**10.** Eine Vorrichtung, umfassend das Zwischenprodukt nach Anspruch 8 oder 9, wobei die Vorrichtung ausgewählt ist aus der Gruppe bestehend aus

- Vorrichtungen, die ein Display enthalten,
- Vorrichtungen, die Licht emittieren,
- Fenstern, und
- Vorrichtungen, die ein optisches Authentifizierungselement enthalten.

**11.** Eine Suspension (5) umfassend

- 0,5 - 80 Gew.-% Nanopartikel (1), wie in Anspruch 1 bis 3 definiert;
- 0,01 - 20 Gew.-% Tenside (2) wie in Anspruch 5 definiert;
- 0,09 - 99 Gew.-% Polymermatrix (3) wie in Anspruch 1 oder 6 definiert;
- 0 - 99 Gew.-% organisches Lösungsmittel (4), ausgewählt aus der Gruppe von Wasser, Alkoholen, Glykolethern, Ketonen und aprotischen polaren Lösungsmitteln.

**12.** Die Suspension nach Anspruch 11, wobei

- die Alkohole aus der Gruppe von Methanol, Ethanol, Isopropanol, Propanol und Butanol ausgewählt sind;
- der Glykolether Propoxy-Ethanol ist;
- die Ketone aus Aceton und MEK ausgewählt sind;
- die aprotischen polaren Lösungsmittel ausgewählt sind aus Dimethylsulfoxid, N-Methylpyrrolidon, Dimethylformamid, Dimethylacetamid.

**13.** Ein Verfahren zur Herstellung einer Suspension nach Anspruch 11 oder 12, wobei das Verfahren die folgenden Schritte umfasst

- Kombinieren eines organischen Lösungsmittels (4), ausgewählt von Wasser, Alkoholen, Glykolethern, Ketonen und aprotischen polaren Lösungsmitteln, die Nanopartikel (1) wie in Anspruch 1-4 definiert und Tensiden (2) wie in Anspruch 5 definiert, um eine erste Suspension zu erhalten;
- Kombinierendes eines organischen Lösungsmittels (4) und der Polymermatrix (3) wie in Anspruch 1 oder 6 definiert um eine erste Lösung zu erhalten;
- Kombinieren der ersten Suspension und der ersten Lösung, um die Suspension zu erhalten.

**14.** Ein Verfahren zur Herstellung eines Hybridmaterials nach einem der Ansprüche 1 bis 6, wobei das Verfahren die folgenden Schritte umfasst

- Bereitstellen einer Suspension nach einem der Ansprüche 11 oder 12;
- Entfernen des organischen Lösungsmittels (4), gegebenenfalls mit Hilfe von vermindertem Druck und / oder Wärme;
- gegebenenfalls Aushärten des so erhaltenen Materials.

**15.** Ein Verfahren zur Herstellung eines Zwischenprodukts nach einem der Ansprüche 8 bis 9, wobei das Verfahren die folgenden Schritte umfasst

- Bereitstellen einer Suspension nach einem der Ansprüche 11 oder 12;
- Bereitstellen eines Trägermaterials, das optional mit einer oder mehreren Schichten beschichtet ist;
- Beschichten / Bedrucken des optional beschichteten Trägermaterials mit der Suspension;
- gegebenenfalls Bereitstellen weiterer Beschichtungen auf dem beschichteten Trägermaterial; und / oder
- gegebenenfalls Nachbehandeln des beschichteten Trägermaterials.

## Revendications

**1.** Un matériau hybride solide (30) comprenant

- 50-90% en poids de nanoparticules (1) choisies dans le groupe des titanates ;
- 1-20% en poids de tensioactifs (2) choisis dans le groupe des acides monocarboxyliques comprenant une queue de polyéther et des esters de phosphate d'éthers d'alkyle ;
- 9-49% en poids de matrice polymère (3) choisie dans le groupe des polymères d'acrylate, des polymères de sulfone, des polymères d'époxy, des polymères de vinyle, des polymères d'uréthane et des polymères d'imide,

**caractérisé en ce que**

- les nanoparticules ont une structure noyau-coquille et le noyau et la coquille sont composés d'oxydes différents, et
- les nanoparticules sont des titanates de formule (I)

$$M_xTi_yO_z \qquad (I),$$

où :

M représente un métal alcalin ou un métal alcalino-terreux,
x représente 0, un nombre réel inférieur à 1 ou 1,
y représente 1 ou un nombre réel inférieur à 1 mais excluant 0,
z représente un nombre réel inférieur à 1 mais excluant 0,
à condition que :

z=x/2+2*y, lorsque M représente un métal alcalin, ou
z=x+2*y lorsque M représente un métal alcalino-terreux, ou
z=2*y lorsque x=0 ; et

- le matériau a de préférence un indice de réfraction >1,75 ; et
- l'enveloppe de la nanoparticule constitue de préférence moins de 20 % en poids (par rapport au poids de l'oxyde) de la nanoparticule totale.

**2.** Le matériau hybride selon la revendication 1, dans lequel les nanoparticules (1) ont une structure noyau-coquille, dans laquelle

- le noyau est un titanate selon la revendication 1 et l'enveloppe est Al2O3 ; et
- la coquille constitue de préférence moins de 20 % en poids (par rapport au poids d'oxyde) de la particule totale.

**3.** Le matériau hybride selon l'une des revendications 1 à 2, dans lequel le titanate est un TiO2 de type rutile.

**4.** Le matériau hybride selon l'une des revendications 1 à 3, comprenant 75-85% en poids de nanoparticules (1).

**5.** Le matériau hybride selon l'une des revendications 1 à 4,
dans lequel le tensioactif est un acide monocarboxylique de formule (II),

$$R(OC_nH_{2n})_qOCH_2C(O)OH \qquad (II),$$

où

R est un groupe alkyle en $C_{1-5}$
q est un nombre entier compris entre 0 et 5,
n est un nombre entier de 1 à 3 ; ou

dans lequel ledit agent tensioactif est un ester de phosphate d'un éther d'alkyle, ledit éther d'alkyle ayant la formule (IV)

$$R_4O\text{-}(C_2H_4O)_m(C_3H_6O)_n\text{-} \qquad (IV)$$

où

$R_4$ est un alkyle en $C_{1-10}$
m est un nombre entier de 2 à 60 ;
n est un nombre entier de 2 à 60.

**6.** Le matériau hybride selon l'une des revendications 1 à 5,
dans lequel les polymères d'acrylate sont obtenus à partir de monomères de formule (V-I) ou (V-II)

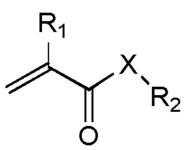
(V-I),
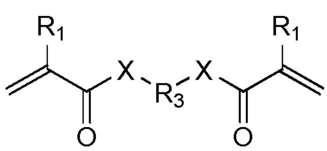
(V-II)

où

$R_1$, indépendamment les uns des autres, est un hydrogène ou un méthyle ;

X est indépendamment un oxygène ou un soufre ;
$R_2$ représente un substituant choisi parmi les groupes phényle, phényl-alkyle en $C_{1-4}$, phényloxy et phényloxy-alkyle en $C_{1-4}$ ;
ledit phényle étant éventuellement substitué par 1 à 3 substituants choisis dans le groupe des alkyle en $C_{1-4}$, phényle, halo, hydroxyle
$R_3$ représente un substituant choisi parmi les groupes phényle, diphényle (Ph-Ph), diphénylsulfyle (Ph-S-Ph), diphényloxy (Ph-O-Ph),
ledit phényle étant éventuellement substitué par 1 à 3 substituants choisis dans le groupe alkyle en $C_{1-4}$, phényle, halogène, hydroxy ;
lesdits polymères de sulfone ayant des unités répétitives de formule (VI),

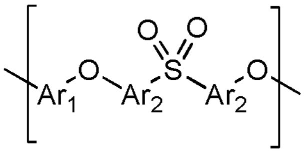
(VI),

où

Ar$_1$ est un phényle, un éther de phényle, un thioéther de phényle, un bisphénol,
ledit phényle étant éventuellement substitué par 1 à 3 substituants choisis dans le groupe alkyle en $C_{1-4}$, phényle, halogène, hydroxyle,
Ar$_2$ représente un phényle,
ledit phényle étant éventuellement substitué par 1 à 3 substituants choisis dans le groupe des alkyle en $C_{1-4}$, phényle, halogène, hydroxy
ledit polymère vinylique comprenant des motifs répétitifs de formule (VII)

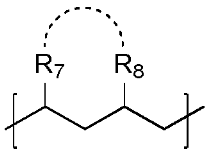
(VII)

où :

$R_7$ représente un hydrogène, un alkyle en $C_{1-4}$, un hydroxy, un cyano, une 2-pyrrolidone,
$R_8$ représente un groupe hydroxy, cyano, 2-pyrrolidone ;
ou dans lequel :
$R_7$, $R_8$ forment ensemble un hétérocycle, où l'hétérocycle est choisi parmi les 1,3-dioxanes, dans lequel l'hétérocycle est éventuellement substitué par 1-3 groupes alkyle en $C_{1-8}$.

**7.** Le matériau hybride selon l'une des revendications 1 à 6 sous forme d'une couche mince ou sous forme de microlentilles,
dans lequel la couche a une épaisseur de 30 nm à 100 μm ; et/ou
dans lequel les microlentilles ont un diamètre de 1 à 500 μm ; et/ou
dans lequel les nanoparticules ont une taille de 5 à 30 nm.

**8.** Un produit intermédiaire (10) comprenant un substrat (20) revêtu d'au moins une couche (30) telle que définie dans la revendication 7.

**9.** Le produit intermédiaire selon la revendication 8 ayant la structure suivante (de bas en haut) :

- substrat (20) / matériau hybride (30) selon l'une des revendications 1 à 6 / électrode transparente (EL) / pile de couches actives, par exemple pile d'émetteurs OLED (AL) agissant comme couche d'adaptation d'indice ; ou.
- substrat (20) / matériau hybride (30) selon l'une des revendications 1 à 6 / électrode transparente (EL) / pile de couches actives, par exemple pile d'émetteurs OLED (AL) agissant comme couche d'extraction de la lumière ;

ou

- ayant la structure suivante (de bas en haut) :
- substrat (20) / unités multiples de couche à faible indice de réfraction (LRI) et matériau hybride (30) selon l'une des revendications 1 à 6, ou substrat (20) / unités multiples de matériau hybride (30) selon l'une des revendications 1 à 6 et couche à faible indice de réfraction (LRI) ; ou
- substrat (20) / matériau hybride (30) selon l'une des revendications 1 à 6 sous forme de microlentilles ; ou
- substrat (20) / matériau hybride (30) selon l'une des revendications 1 à 6 comprenant un empilement supplémentaire d'éléments de diffusion (SE) / électrode transparente (EL) / couche active, par exemple un empilement d'émetteurs OLED (AL) agissant comme couche d'extraction de la lumière.

**10.** Un dispositif comprenant le produit intermédiaire selon la revendication 8 ou 9, dans lequel le dispositif est choisi dans le groupe constitué par

- des dispositifs qui comprennent un écran,
- des dispositifs qui émettent de la lumière,
- des fenêtres, et
- des dispositifs contenant un élément d'authentification optique.

**11.** Une suspension (5) comprenant

- 0,5 - 80% en poids de nanoparticules (1) telles que définies dans les revendications 1 à 3 ;
- 0,01 - 20% en poids de tensioactifs (2) tels que définis dans la revendication 5 ;
- 0,09 - 99 % en poids de matrice polymère (3) telle que définie dans la revendication 1 ou 6 ;
- 0 - 99 % en poids de solvant organique (4) choisi dans le groupe des eaux, alcools, éthers de glycol, cétones et solvants polaires aprotiques.

**12.** La suspension selon la revendication 11, dans laquelle

- les alcools sont choisis dans le groupe constitué par le méthanol, l'éthanol, l'isopropanol, le propanol et le butanol ;
- l'éther de glycol est le propoxyéthanol ;
- les cétones sont choisies parmi l'acétone et le MEK ;
- les solvants polaires aprotiques sont choisis parmi le diméthylsulfoxyde, la N-méthylpyrrolidone, le diméthylformamide, le diméthylacétamide.

**13.** Un procédé de préparation d'une suspension selon la revendication 11 ou 12, le procédé comprenant les étapes suivantes .

- combiner un solvant organique (4) choisi parmi l'eau, les alcools, les éthers de glycol, les cétones et les solvants polaires aprotiques contenant des nanoparticules (1) telles que définies dans la revendication 1-4 et des tensioactifs (2) tels que définis dans la revendication 5 pour obtenir une première suspension ;
- combiner un solvant organique (4) et la matrice polymère (3) telle que définie dans la revendication 1 ou 6 pour obtenir une première solution ;
- combiner la première suspension et la première solution pour obtenir la suspension.

**14.** Un procédé de préparation d'un matériau hybride selon l'une quelconque des revendications 1 à 6, le procédé comprenant les étapes suivantes .

- mettre à disposition une suspension selon l'une des revendications 11 ou 12 ;
- éliminer le solvant organique (4), éventuellement à l'aide d'une pression réduite et/ou de la chaleur ;
- éventuellement, durcir le matériau ainsi obtenu.

**15.** Un procédé de préparation d'un intermédiaire selon l'une des revendications 8 à 9, le procédé comprenant les étapes suivantes

- mettre à disposition une suspension selon l'une des revendications 11 ou 12 ;
- fournir un matériau de support éventuellement revêtu d'une ou plusieurs couches ;
- revêtir/imprimer le matériau de support éventuellement revêtu avec la suspension ;

- fournir éventuellement d'autres revêtements sur le matériau de support revêtu ; et/ou
- éventuellement post-traiter le matériau de support revêtu.

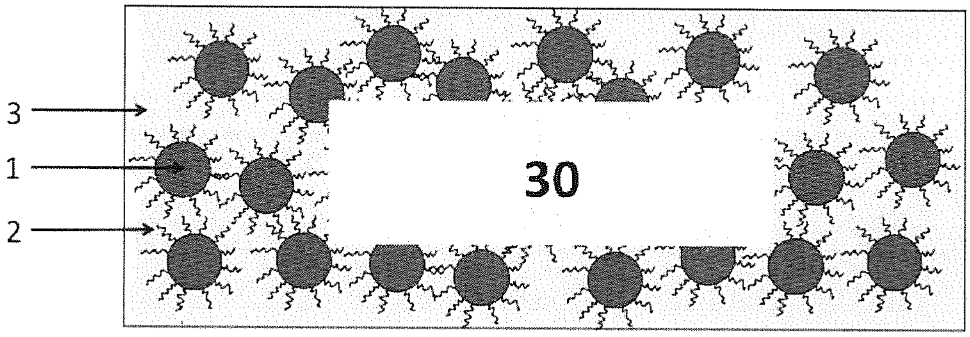


Fig. 1

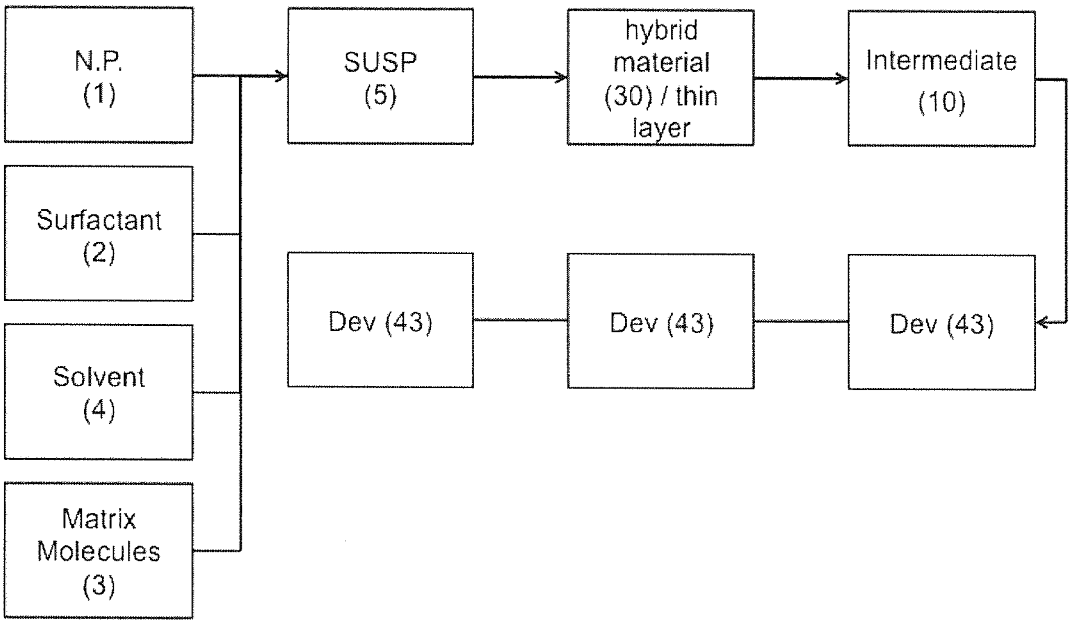


Fig. 2

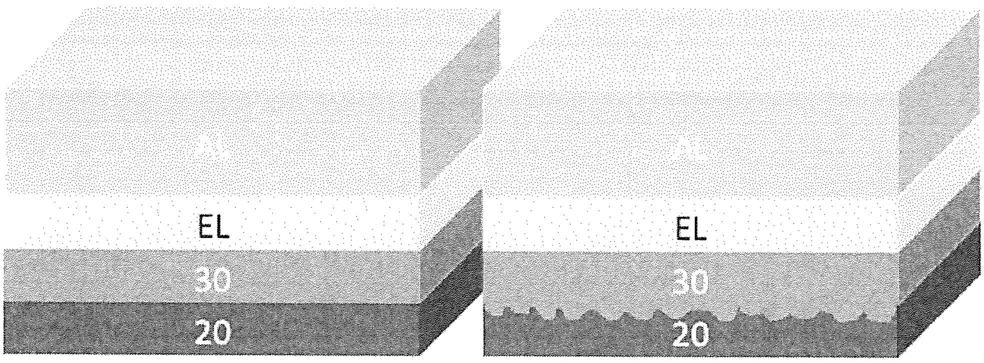


Fig. 3 A B

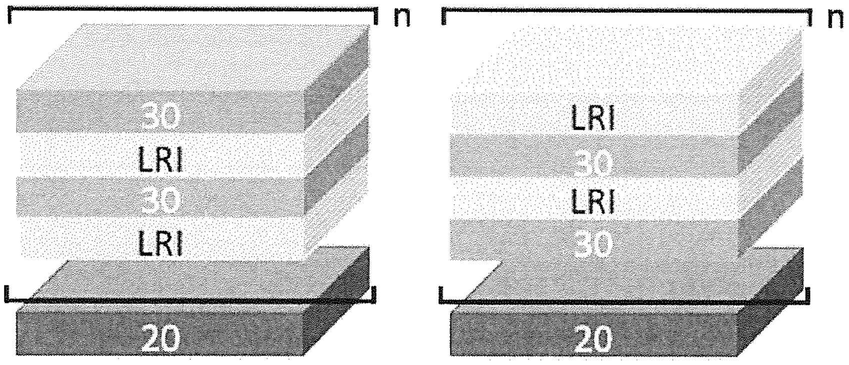


Fig. 4

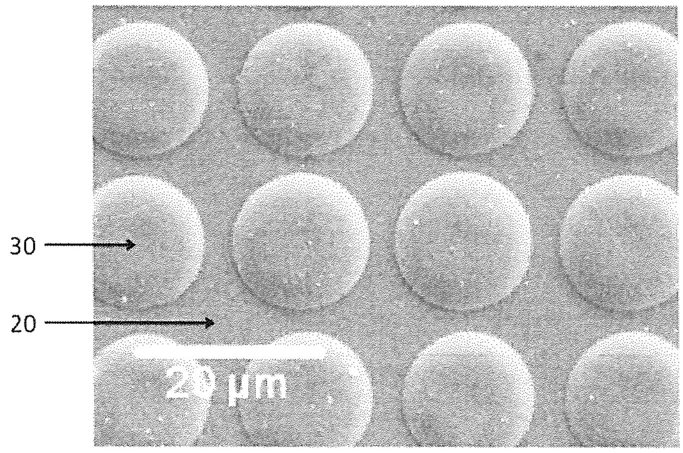


Fig 5

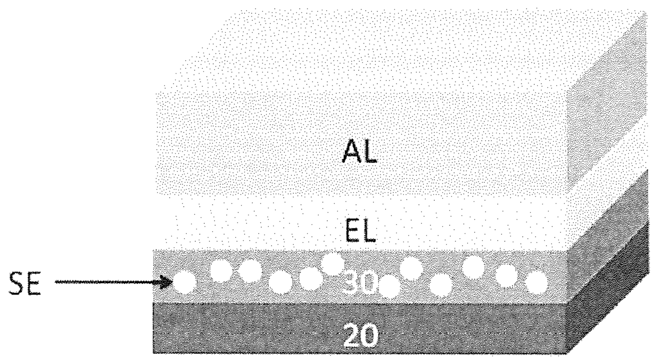


Fig. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2010002562 A, Liu
- EP 2586826 A, Yamazaki
- US 20140045323 A, Gonen Williams
- JP 2006325069 B
- JP 2009185166 B


### Non-patent literature cited in the description


- **LIU et al.** *Colloids and Surfaces A: Physicochem. Eng. Aspects,* 2011, vol. 377, 138-143
- **RUSSO et al.** *J. of Polym. Sci.,* 2012, vol. 50, 65-74
- **BOSCH-JIMENEZ et al.** *J. Colloid and Interface Sci.,* 2014, vol. 416, 112-118